# EUROPÄISCHE PATENTSCHRIFT

(11) **EP 1 600 782 B1**
(45) Veröffentlichungstag und Bekanntmachung des Hinweises auf die Patenterteilung: **23.04.2008**
(21) Anmeldenummer: 05001875.3
(22) Anmeldetag: 29.01.2005
(51) Int. Cl.: G01R 1/073

(54) **Prüfeinrichtung zur elektrischen Prüfung eines Prüflings sowie Verfahren zur Herstellung einer Prüfeinrichtung**
Testing device for electronic testing of a sample and method for producing a device
Dispositif de test électronique d'un échantillon et procédé pour la fabrication d'un dispositif

(30) Priorität: 28.05.2004 DE 102004027886
(43) Veröffentlichungstag der Anmeldung: 30.11.2005
(73) Patentinhaber: Feinmetall GmbH, 71083 Herrenberg (DE)
(72) Erfinder: Böhm, Gunther, 71154 Nufringen (DE); Holocher, Michael, 72108 Rottenburg (DE)
(74) Vertreter: Grosse, Rainer

(56) Entgegenhaltungen:
- EP-A- 0 343 021
- WO-A-01/09980
- US-B1- 6 576 301

## Beschreibung

Die Erfindung betrifft eine Prüfeinrichtung zur elektrischen Prüfung eines Prüflings, insbesondere zur Prüfung von Wafern, mit einem dem Prüfling zuzuordnenden, mit eine Kontaktstiftanordnung bildenden, stiftförmigen Kontaktelementen versehenen Kontaktkopf und mit einer elektrischen Anschlussvorrichtung, die Kontaktflächen aufweist, die mit den, der den Prüfling aufnehmenden Prüfebene abgewandten Enden der Kontaktelemente in Berührungskontakt stehen.

Elektrische Prüfeinrichtung der eingangs genannten Art dienen dazu, einen Prüfling elektrisch zu kontaktieren, um seine Funktionsfähigkeit zu testen.

Die EP-A-0 343 021 (AUGAT INC) beschreibt daß die Kontaktnadeln mechanisch bearbeitet werden um eine Planarität herzustellen. Ein nachgiebiges dielektrisches material wird ebenfalls verwendet um die Längenunterschiede auszugleichen.

Die elektrische Prüfeinrichtung stellt elektrische Verbindungen zum Prüfling her, d.h., sie kontaktiert einerseits elektrische Anschlüsse des Prüflings und stellt andererseits elektrische Kontakte zur Verfügung, die mit einem Prüfsystem verbunden werden, das über die Prüfeinrichtung dem Prüfling elektrische Signale zuführt, um für eine Funktionsprüfung beispielsweise Widerstandsmessungen, Strom- und Spannungsmessungen und so weiter durchzuführen. Da es sich bei dem elektrischen Prüfling oftmals um sehr kleine elektronische Bauelemente handelt, beispielsweise um elektronische Schaltungen auf einem Wafer, aus dem elektronische Bauelemente gefertigt werden, besitzen die stiftförmigen Kontaktelemente des Prüfkopfs extrem kleine Abmessungen. Um nun eine Anschlussmöglichkeit zum erwähnten Prüfsystem zu schaffen, stehen die Kontaktelemente des Prüfkopfs in Berührungskontakt mit einer Anschlussvorrichtung, die eine Umsetzung auf einen größeren Kontaktabstand vornimmt und insofern das Anschließen von elektrischen Verbindungskabeln er-möglicht, die zum Prüfsystem führen. Bei der Prüfung befindet sich der Prüfling in der Prüfebene und die Prüfeinrichtung wird axial, vorzugsweise in vertikaler Richtung, auf den Prüfling abgesenkt, so dass die einen Enden der stiftförmigen Kontaktelemente den Prüfling kontaktieren und die anderen Enden der stiftförmigen Kontaktelemente gegen die Kontaktflächen der Anschlussvorrichtung treten. Aufgrund von Fertigungstoleranzen und äußeren Bedingungen ist nicht immer sichergestellt, dass die Kontaktstifte der Kontaktstiftanordnung mit etwa gleichem Anpressdruck den Prüfling kontaktieren, da schon eine geringe Abweichung von der Planarität eines Bauteils dazu führen kann, dass ein bestimmter Anteil der Kontaktstifte oder nur ein einzelner Kontaktstift frühzeitig beim Absenken den Prüfling kontaktiert oder erst zu einem Kontakt kommt, wenn bereits alle oder viele andere Kontaktstifte Kontakt haben, wobei bei der Prüfung auch ein stärkerer oder ein geringerer Kontaktdruck bei bestimmten Kontaktstiften vorliegen kann. Schlimmstenfalls kann es bei der bekannten Prüfeinrichtung vorkommen, dass bestimmte Kontaktstifte keinen Kontakt zum Prüfling erhalten, obwohl andere Kontaktstifte mit gewünschtem Kontaktdruck gegen den Prüfling anlegen. Geringfügige Abweichungen gleichen die Kontaktstifte vorzugsweise von sich aus aus, da sie in Längsrichtung federnd, beispielsweise als Knickdrähte ausgebildet sind. Knickdrähte werden bei der Kontaktierung in Längsrichtung beaufschlagt und biegen sich hierbei leicht bogenförmig elastisch durch. Dieser Ausgleich ist jedoch nicht immer ausreichend. Der Erfindung liegt daher die Aufgabe zugrunde, eine Prüfeinrichtung der eingangs genannten Art zu schaffen, bei der stets eine sichere Kontaktierung des Prüflings gewährleistet ist.

Diese Aufgabe wird erfindungsgemäß dadurch gelöst, dass die Kontaktflächen an sich in axialer Richtung erstreckenden Axialkontaktelementen als mechanisch bearbeitete Kontaktflächen ausgebildet sind. Die mechanische Bearbeitung sieht insbesondere Schleifen, Fräsen und/oder Hobeln vor. Es können natürlich auch bekannte andere mechanische Bearbeitungsvorgänge zum Einsatz gelangen, die Material abtragen. Die Kontaktflächen befinden sich demgemäß an Axialkontaktelementen, also an sich in axialer Richtung erstreckenden Bauteilen. Beispielsweise können diese Bauteile als axiale Kontaktsäulen oder axiale Kontakterhöhungen ausgebildet sein. Diese Axialkontaktelemente werden zur Erzeugung der Kontaktflächen zum Beispiel durch Fräsen bearbeitet oder beschliffen, um eine definierte axiale Position der Kontaktfläche herzustellen. Auf diese Art und Weise lässt sich hochgenau die Axialposition der Kontaktfläche erstellen, so dass es im Zusammenwirken mit den Kontaktelementen stets zu einer sicheren Kontaktierung mit dem Prüfling kommt, da die axiale Position der Kontaktfläche aufgrund des erfindungsgemäßen Vorgehens derart erzeugt werden kann, dass ein zu starker Kontaktdruck oder ein schwacher Kontaktdruck oder gar ein fehlender Kontaktdruck nicht auftritt.

Insbesondere kann vorgesehen sein, dass die Kontaktflächen jeweils für sich durch mechanische Bearbeitung hergestellt werden oder als mittels eines einzigen mechanischen Bearbeitungsvorgangs erzeugte Kontaktflächen ausgebildet sind. Demzufolge werden gemäß der zweiten Alternative alle Kontaktflächen der Anschlussvorrichtung gemeinsam mittels eines einzigen mechanischen Bearbeitungsvorgangs erzeugt. Hierdurch lässt sich beispielsweise eine exakte Planarität erzielen oder auch Anordnungen, bei der bewusst von einer Planarität abgewichen wird (in sich plane Schrägfläche).

Es ist vorteilhaft, wenn die Kontaktflächen als jeweils für sich und auch zueinander mechanisch planar bearbeitete Kontaktflächen ausgebildet sind. Dies bedeutet, dass eine perfekte Ebenheit der Gesamtanordnung vorliegt, die die Voraussetzung einer sicheren Kontaktierung bietet. Wenn die Kontaktelemente der Kontaktstiftanordnung ebenfalls vorzugsweise gemeinsam mittels eines (anderen) mechanischen Bearbeitungsvorgangs, zum Beispiel Schleifvorganges, auf gleiche Länge und damit als Gesamtanordnung planar geschliffen wurden, arbeitet eine entsprechend planar geschliffene Anschlussvorrichtung perfekt mit diesen Kontaktelementen zusammen, so dass es in axialer Richtung zu keinen derart großen Toleranzabweichungen kommt, die eine sichere Kontaktierung gefährden könnte.

Die Axialkontaktelemente können durch Materialauftrag auf Grundkontakte der Anschlussvorrichtung hergestellt werden. Dies kann beispielsweise dadurch erfolgen, dass Lot auf die Grundkontakte aufgebracht und mit diesen verlötet wird, so dass es zu entsprechenden Loterhöhungen kommt. Diese Loterhöhungen werden anschließend beschliffen, um die Kontaktflächen in gewünschter axialer Lage zu erhalten. Alternativ ist es beispielsweise möglich, Axialkontaktelemente dadurch zu erstellen, dass Leitkörper mit den Grundkontakten beispielsweise verlötet, verschweißt oder mit elektrisch leitfähigem Kleber verklebt werden, und anschließend eine mechanische Bearbeitung, zum Beispiel ein Beschleifen, der Leitkörper durchgeführt wird. Beispielsweise können winzige säulenförmige Leitkörper zum Einsatz kommen, die an den Grundkontakten elektrisch leitend befestigt werden.

Insbesondere kann vorgesehen sein, dass die Anschlussvorrichtung eine Leiterplatte, insbesondere eine mehrlagige Leiterplatte, aufweist. Die Leiterplatte besitzt auf einer Seite die erwähnten Grundkontakte, die über Leiterbahnen zu radial außenliegenden Anschlusskontakten führen, an denen die zum Prüfsystem führenden elektrischen Verbindungskabel angeschlossen werden. Als Kontakterhöhungen können bei Verwendung einer Leiterplatte als Anschlussvorrichtung bevorzugt Durchkontaktierungen zum Einsatz kommen, d.h., die Axialkontaktelemente werden von Durchkontaktierungen der Leiterplatte gebildet. Die mehrlagige Leiterplatte weist bevorzugt eine äußere Lage auf, die dem Kontaktkopf zugeordnet ist und die die Durchkontaktierungen aufweist. Wird die gesamte äußere Lage, also die Oberfläche dieser außenliegenden Lage der Leiterplatte mechanisch bearbeitet, so wird nicht nur das Isoliermaterial der Leiterplatte entsprechend bearbeitet, sondern auch die dort liegenden Durchkontaktierungen, die insofern auf das gewünschte axiale Niveau durch die Bearbeitung gebracht werden können. Die Durchkontaktierungen können metallisierte Wandungen aufweisen und daher zu den Kontaktstiften der Kontaktstiftanordnung weisende ringförmige Kontaktflächen bilden. Sofern die Kontaktstifte im Durchmesser größer ausgebildet sind, als der freie innere Durchmesser einer derartigen ringförmigen Kontaktanordnung, ist ein Eintauchen eines Kontaktstiftes nicht zu befürchten. Sofern allerdings vollvolumige Durchkontaktierungen zum Einsatz kommen, liegen in sich geschlossene Kontaktflächen vor, die die Kontaktsicherheit erhöhen.

Die Erfindung betrifft ferner ein Verfahren zur Herstellung einer Prüfeinrichtung, insbesondere nach einer oder mehreren der vorhergehenden Erläuterungen, wobei die Kontaktflächen der Anschlussvorrichtung durch mechanisches Bearbeiten, insbesondere durch mechanisches Planbearbeiten, hergestellt werden. Insbesondere wird zur Erstellung der Kontaktflächen zunächst eine Auffutterung mit leitendem Material vorgenommen, das dann mechanisch bearbeitet wird.

Die Zeichnungen veranschaulichen die Erfindung anhand von Ausführungsbeispielen und zwar zeigt:
- Figur 1: eine schematische Querschnittsansicht durch eine elektrische Prüfeinrichtung,
- Figur 2: eine Detailansicht der Prüfeinrichtung der Figur 1,
- Figur 3: eine Detailansicht eines weiteren Ausführungsbeispiels einer Prüfeinrichtung,
- Figur 4: eine Detailansicht eines weiteren Ausführungsbeispiels einer Prüfeinrichtung und
- Figur 5: eine Detailansicht eines weiteren Ausführungsbeispiels einer Prüfeinrichtung.

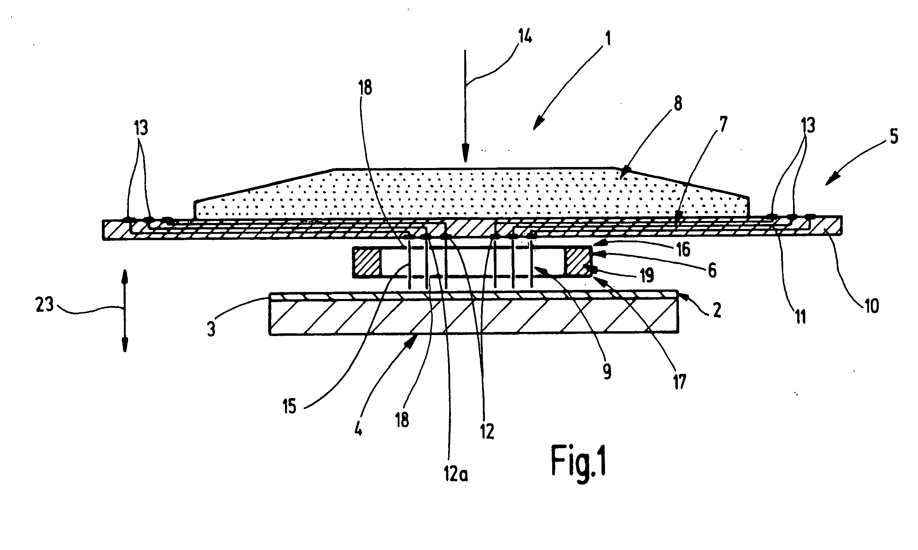

Die Figur 1 zeigt in schematischer Darstellung den Querschnitt durch eine elektrische Prüfeinrichtung 1, die zur Kontaktierung eines Prüflings 2 mittels einer nicht dargestellten elektrischen Kabelverbindung an ein nicht dargestelltes Prüfsystem angeschlossen werden kann, um den Prüfling 2 einer elektrischen Prüfung zu unterziehen. Der Prüfling 2, der zum Beispiel als Wafer 3 ausgebildet ist, befindet sich auf einem abstützenden Träger 4, der als Chuck bezeichnet wird und gekühlt oder geheizt werden kann. Auf diese Art und Weise ist es möglich, den Prüfling 2 während der elektrischen Prüfung unterschiedlichen Temperaturen auszusetzen, beispielsweise im Bereich von minus 50°C bis plus 200°C, um zu prüfen, ob er in diesem Temperaturbereich einwandfrei arbeitet.

Zur Kontaktierung entsprechender Anschlussstellen des Wafers 3 ist eine Vertikal-Prüfkarte 5 vorgesehen, die die Prüfeinrichtung 1 bildet.

Die Prüfeinrichtung 1 weist einen Kontaktkopf 6 und eine Anschlussvorrichtung 7 auf. Die Anschlussvorrichtung 7 stützt sich an einer Abstützvorrichtung 8 ab. Der Kontaktkopf 6 ist mit einer Vielzahl von längsverschieblich gelagerten Kontaktelementen 9 versehen, die mit ihren einen Endbereichen dem Prüfling 2 und mit ihren anderen Endbereichen der Anschlussvorrichtung 7 zugeordnet sind. Die Anschlussvorrichtung 7 ist als mehrlagige Leiterplatte 10 mit Leiterbahnen 11 ausgebildet, wobei die Leiterbahnen 11 an ihren dem Kontaktkopf 6 zugeordneten Enden Grundkontakte 12a von Kontakten 12 aufweisen, die den jeweiligen Kontaktelementen 9 zugeordnet sind und wobei die Leiterbahnen 11 an ihren radial außenliegenden Enden elektrische Anschlussflächen 13 besitzen, die über die erwähnten, nicht dargestellten Kabelverbindungen mit dem Prüfsystem (ebenfalls nicht dargestellt) verbindbar sind. Die Anordnung ist derart getroffen, dass die Anschlussvorrichtung 7 eine Umsetzvorrichtung bildet, d.h., der sehr enge Abstand der winzig kleinen Grundkontaktflächen 12b der Grundkontakte 12a (Durchmesser zum Beispiel 50 bis 300 µm) wird über die Leiterbahnen 11 in größere Abstände der Anschlussflächen 13 umgesetzt. Auch haben die Anschlussflächen 13 jeweils eine Größe, um die Kabelverbindungen zum Prüfsystem herstellen zu können.

Bei der Prüfung des Prüflings 2 bewegt sich die Prüfeinrichtung 1 in axialer Richtung (Pfeil 14) auf dem Prüfling 2 zu, wobei die Leiterplatte 10 von der Abstützvorrichtung 8 abgestützt wird. Die Stirnenden der Kontaktelemente 9 treffen einerseits auf den Wafer 3 und andererseits auf die Kontakte 12. Da die Kontaktelemente 9 als Knickdrähte 15 ausgebildet sind, d.h., in axialer Richtung durch Durchbiegung leicht federnd gestaltet sind, ist eine einwandfreie Kontaktierung möglich, sofern bei planem Wafer 3 und gleicher Länger aller Knickdrähte 15 sich die Kontaktflächen 12c der Kontakte 12 ebenfalls auf zueinander gleicher Höhe befinden, also ebenfalls eine Planarität vorliegt. Wie diese Planarität der Kontakte 12 erreicht werden kann, wird nachstehend noch näher ausgeführt.

Der Kontaktkopf 6 besitzt zwei mit Abstand zueinander liegende parallele Keramikplatten 16 und 17, die mit Lagerbohrungen 18 zur Aufnahme der Knickdrähte 15 versehen sind. Die parallele Abstandlage der beiden Keramikplatten 16 und 17 wird mittels eines Abstandshalters 19 realisiert.

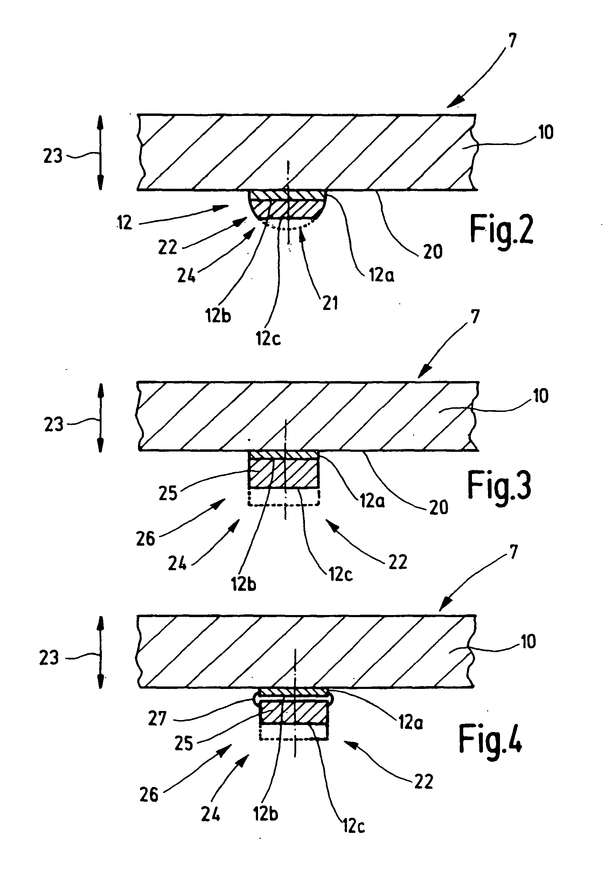

Die Figur 2 zeigt einen Bereich der Prüfeinrichtung 1, und zwar einen Abschnitt der Anschlussvorrichtung 7. Auf der Unterseite 20 der Leiterplatte 10 befinden sich die Kontakte 12, von denen einer in der Figur 2 dargestellt ist. Der Kontakt 12 besteht aus dem Grundkontakt 12a, der als Leiterbahnpad ausgebildet ist und mit einer entsprechenden, in der Figur 2 nicht dargestellten Leiterbahn in Verbindung steht. Auf die Grundkontaktfläche 12b des Grundkontakts 12a ist eine Loterhöhung 21 aufgebracht. Bei der Loterhöhung 21 handelt es sich um ein Lotmaterial, zum Beispiel eine Lötzinnkugel, das aufgeschmolzen wurde, so dass sich auf dem Grundkontakt 12a eine "buckelförmige" Erhöhung bildet. In der Figur 2 ist diese Loterhöhung 21 zur Kennzeichnung ihrer ursprünglichen Form im unteren zentralen Bereich mit gepunkteter Linie dargestellt. Da sich an der Unterseite 20 der Leiterplatte 10 eine Vielzahl von Grundkontakten 12a befindet und auf jedem Grundkontakt 12a eine entsprechende Loterhöhung 21 aufgebracht wird, entstehen eine Vielzahl von Axialkontaktelemente 22. Hierunter ist jeweils der gesamte Kontakt 12 zu verstehen. Da sich der Kontakt 12 in axialer Richtung (Doppelpfeil 23) in Figur 1 und Figur 2 erstreckt, ist jeweils ein sich in axialer Richtung entsprechend aufgebautes Kontaktelement vorhanden, das zu der gewählten Bezeichnung "Axialkontaktelement" führt.

Da die einzelnen Axialkontaktelemente 22 aufgrund der jeweils aufgeschmolzenen Lötzinnkugel entsprechende Toleranzmaße in axialer Richtung mit sich bringen, werden bei der Herstellung sämtliche Axialkontaktelemente 22 mittels eines gemeinsamen mechanischen Bearbeitungsvorgangs, insbesondere Präzisions-Fräsvorgangs und/oder Präzisions-Schleifvorgangs, an ihrem unteren Ende 24 plan gearbeitet, insbesondere gefräst und/oder geschliffen, wodurch sich jeweils eine Kontaktfläche 12c, insbesondere eine gefräste und/oder geschliffene Kontaktfläche 12c, an jedem Axialkontaktelement 22 ausbildet. Sämtliche Kontaktflächen 12c sind durch den Fräsvorgang und/oder Schleifvorgang in sich plan und liegen auch plan zueinander und sind zusätzlich planar zur Oberseite des Trägers 4 und damit planar zum beispielsweise als Wafer 3 ausgebildeten Prüfling 2. Die Knickdrähte 15 sind bei ihrer Herstellung ebenfalls durch einen mechanischen Bearbeitungsvorgang, insbesondere ebenfalls durch einen Fräsvorgang und/oder Schleifvorgang, alle auf gleiche Länge gebracht worden, so dass insgesamt eine exakt planare Prüfeinrichtung 1 geschaffen ist, d.h., bei der Kontaktierung eines Prüflings 2 ist sichergestellt, dass keine "voreilenden" oder "nacheilenden" Kontaktierungen beim Absenken der Prüfeinrichtung 1 auf den Prüfling 2 stattfinden und dass sämtliche Kontaktelemente 9 mit zumindest im Wesentlichen gleichen Kontaktierungsdruck die entsprechenden Prüfpunkte des Prüflings beaufschlagen.

Die Figur 3 zeigt ein weiteres Ausführungsbeispiel einer Prüfeinrichtung 1, bei der in Abweichung zum Ausführungsbeispiel der Figur 2 an der Unterseite 20 der Anschlussvorrichtung 7 beziehungsweise Leiterplatte 10 der jeweilige Kontakt 12 dadurch erstellt ist, dass auf den Grundkontakt 12a ein Leitkörper 25 befestigt ist. Dies erfolgt vorzugsweise durch Verschweißen der entsprechenden Stirnseite des Leitkörpers mit der Grundkontaktfläche 12b. Bei dem Leitkörper 25 kann es sich beispielsweise um winzige zylindrische, elektrisch leitende Kontaktteile handeln. Hierdurch werden an der Unterseite 20 der Leiterplatte 10 Leitkörpererhöhungen 26 geschaffen, die -zur Erzielung einer Planaranordnung- im Bereich ihres freien Endes 24 im Zuge eines gemeinsamen mechanischen Bearbeitungsvorgangs bearbeitet werden, wodurch zum Beispiel gefräste und/oder geschliffene Kontaktflächen 12c entstehen. Der abgetragene Materialbereich ist in der Figur 3 mittels der gepunkteten Linie angedeutet.

Die Figur 4 zeigt ein Ausführungsbeispiel einer mit Axialkontaktelementen 22 versehenen Prüfeinrichtung 1, das dem Ausführungsbeispiel der Figur 3 entspricht. Unterschiedlich ist lediglich, dass der Leitkörper 25 an dem Grundkontakt 12a nicht durch Schweißung, sondern durch Lötung befestigt ist. Aus der Figur 4 ist die Lötverbindung 27 erkennbar. Ansonsten erfolgt -ebenso wie bei den Ausführungsbeispielen der vorherigen Figuren- ein mechanischer Präzisionsbearbeitungsvorgang, um die planaren Kontaktflächen 12c herzustellen.

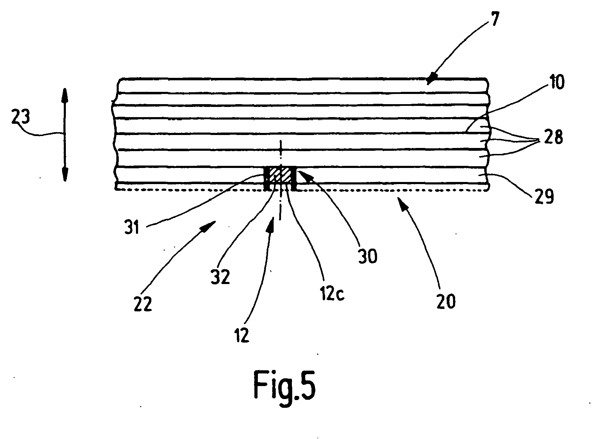

Beim Ausführungsbeispiel der Figur 5 ist das jeweilige, sich in axialer Richtung erstreckende Axialkontaktelement 22 dadurch geschaffen, dass die Anschlussvorrichtung 7 als mehrlagige Leiterplatte 10 ausgebildet ist, die eine entsprechende Anzahl von Lagen 28 mit zugeordneten, nicht dargestellten Leiterbahnen aufweist, wobei die unterste Lage 29 zur Schaffung des jeweiligen Axialkontaktelements 22 eine Durchkontaktierung 30 aufweist. Das bedeutet, dass die Lage 29 eine Axialbohrung 31 aufweist, in der sich leitfähiges Material 32 vorzugsweise vollvolumig befindet, das mit einer entsprechenden, nicht dargestellten Leiterbahn in Verbindung steht. Zur Schaffung der planaren Kontaktfläche 12c jedes Kontaktes 12, wird vorzugsweise in einem einzigen Arbeitsgang die gesamte Unterseite 20 der Leiterplatte 10 mechanisch plan gearbeitete, so dass sowohl Isoliermaterial, als auch Material der Durchkontaktierungen 30 abgetragen werden und insgesamt eine planare Fläche erzeugt wird, in der sich die mechanisch bearbeiteten Kontaktflächen 12c der Durchkontaktierungen 30 befinden, wobei aufgrund der Durchkontaktierungen sich jeweils in axialer Richtung erstreckende Axialkontaktelemente 22 vorliegen.

Aufgrund des erfindungsgemäßen Vorgehens, nämlich des mechanischen Bearbeitens, insbesondere Fräsen und/oder Beschleifens von vorzugsweise säulenartigen Kontakterhöhungen, werden bearbeitete Kontaktflächen 12c an der Anschlussvorrichtung 7 erzeugt, die jeweils in sich planar sind und auch zueinander eine planare Lage aufweisen. Die Durchmesser dieser mechanisch bearbeiteten Kontaktflächen 12c belaufen sich etwa auf 50 bis 300 µm. Die einzelnen voneinander elektrisch isolierten Kontaktflächen 12c haben etwa einen Mittenabstand von 100 bis 300 µm voneinander. Dieser Mittenabstand ist selbstverständlich von der Kontaktlage des jeweils zu testenden Prüfling 2 abhängig.

Insbesondere kann vorgesehen sein, dass die vorstehend erwähnten Kontakterhöhungen, zum Beispiel Loterhöhungen oder durch Axialkontaktelemente geschaffene Kontakterhöhungen, vor dem mechanischen Bearbeiten, insbesondere Überfräsen oder Überschleifen, in eine Einbettungsmasse eingebettet werden, die elektrisch nicht leitend ist. Hier kann es sich beispielsweise um eine Kunststoffmasse handeln. Der Vorteil besteht dann darin, dass die sehr empfindlichen Kontakterhöhungen beim mechanischen Bearbeitungsvorgang mechanisch abgestützt und daher bestens geschützt sind, sodass die Erhöhungen bei der mechanischen Bearbeitung einem nur sehr geringem mechanischen Stress ausgesetzt sind. So ist es beispielsweise möglich, die Erhöhungen in Epoxydharz einzubetten, anschließend -nach Aushärtung- den mechanischen Bearbeitungsprozess durchzuführen, wobei bei der mechanischen Bearbeitung das aufgebrachte Stützmaterial entweder vollständig wieder entfernt wird oder auch teilweise auf dem Produkt verbleibt, je nachdem wie weitgehend die mechanische Bearbeitung erfolgt. Grundsätzlich ist anzumerken, dass sich eine Vielzahl von verschiedenen Einbettungsmaterialen für die genannte Stützfunktion eignet, wobei das Einbettungsmaterial teilweise auf dem Werkstück belassen oder auch wieder entfernt wird.

Die Erfindung zeichnet sich auch dadurch aus, dass nach der mechanischen Bearbeitung -unabhängig vom jeweiligen Ausführungsbeispiel- die Oberfläche der Kontaktflächen noch veredelt wird, um eine robuste Oberfläche mit guten elektrischen Kontakteigenschaften zu schaffen. Beispielsweise kann ein chemisches oder elektrochemisches Vergolden vorgenommen werden. Natürlich sind auch andere Metalle aufbringbar, um die gewünschte Wirkung zu erzielen. Eine derartige Ausführungsform sieht insbesondere vor, eine aus Lötmaterial, insbesondere Lötzinn, bestehende Erhöhung nach der mechanischen Bearbeitung mit einem Schichtaufbau zu versehen, der aus Gold, Nickel und wieder Gold besteht. Die verschiedenen Materialien werden nacheinander elektrochemisch aufgebracht.

Denkbar ist es auch, eine nach der mechanischen Bearbeitung auf die jeweilige Kontaktfläche aufgebrachte Oberflächenschicht der genannten Art nochmals mechanisch zu bearbeiten. Diese Bearbeitung wird nur in einem geringen Umfang durchgeführt, um die Oberflächenschicht nicht wieder vollständig abzutragen.

## Patentansprüche

1. Prüfeinrichtung (1) zur elektrischen Prüfung eines Prüflings (2), insbesondere zur Prüfung von Wafern (3), mit einem dem Prüfling (2) zuzuordnenden, mit eine Kontaktstiftanordnung bildenden, stiftförmigen Kontaktelementen (9) versehenen Kontaktkopf (6) und mit einer elektrischen Anschlussvorrichtung (7), die Kontaktflächen aufweist, die mit den, der den Prüfling (2) aufnehmenden Prüfebene abgewandten Enden der Kontaktelemente (9) in Berührungskontakt stehen, **dadurch gekennzeichnet, dass** die Kontaktflächen an sich in axialer Richtung erstreckenden Axialkontaktelementen (22) als mechanisch bearbeitete Kontaktflächen (12c) ausgebildet sind.

2. Prüfeinrichtung nach Anspruch 1, **dadurch gekennzeichnet, dass** die Kontaktflächen als mittels eines einzigen mechanischen Bearbeitungsvorgangs erzeugte Kontaktflächen (12c) ausgebildet sind.

3. Prüfeinrichtung nach Anspruch 1, **dadurch gekennzeichnet, dass** die Kontaktflächen als jeweils für sich und auch zueinander mechanisch planarbearbeitete Kontaktflächen (12c) ausgebildet sind.

4. Prüfeinrichtung nach einem der vorhergehenden Ansprüche, **dadurch gekennzeichnet, dass** die Axialkontaktelemente (22) Loterhöhungen (21) sind.

5. Prüfeinrichtung nach einem der vorhergehenden Ansprüche, **dadurch gekennzeichnet, dass** die Axialkontaktelemente (22) verlötete oder verschweißte Leitkörpererhöhungen (26) sind.

6. Prüfeinrichtung nach einem der vorhergehenden Ansprüche, **dadurch gekennzeichnet, dass** die Anschlussvorrichtung (7) eine Leiterplatte (10), insbesondere eine mehrlagige Leiterplatte (10) aufweist.

7. Prüfeinrichtung nach einem der vorhergehenden Ansprüche, **dadurch gekennzeichnet, dass** die Axialkontaktelemente (22) Durchkontaktierungen (30) der Leiterplatte (10) sind.

8. Prüfeinrichtung nach einem der vorhergehenden Ansprüche, **dadurch gekennzeichnet, dass** die Leiterplatte (10) eine mehrlagige Leiterplatte ist und dass sich die Durchkontaktierungen (30) in einer äußeren Lage (29) der Leiterplatte (10) befinden.

9. Prüfeinrichtung nach einem der vorhergehenden Ansprüche, **dadurch gekennzeichnet, dass** die Lage (29) der Leiterplatte (10) zusammen mit den Durchkontaktierungen (30) eine mechanisch bearbeitete Oberfläche aufweist.

10. Prüfeinrichtung nach einem der vorhergehenden Ansprüche, **dadurch gekennzeichnet, dass** die Durchkontaktierungen (30) vollvolumig, insbesondere vollvolumig metallisiert, ausgebildet sind.

11. Prüfeinrichtung nach einem der vorhergehenden Ansprüche, **dadurch gekennzeichnet, dass** die Axialkontaktelemente (22) in eine elektrisch nichtleitende, aushärtende Einbettungsmasse eingebettet sind.

12. Prüfeinrichtung nach einem der vorhergehenden Ansprüche, **dadurch gekennzeichnet, dass** auf den Kontaktflächen nach der mechanischen Bearbeitung mindestens eine elektrisch leitfähige Beschichtung aufgebracht ist.

13. Prüfeinrichtung nach Anspruch 12, **dadurch gekennzeichnet, dass** mehrere Beschichtungen aus gleichen und/oder unterschiedlichen Materialien nacheinander auf die Kontaktflächen aufgebracht sind.

14. Verfahren zur Herstellung einer Prüfeinrichtung nach einem oder mehreren der vorhergehenden Ansprüche, bei der die Kontaktflächen (12c) der Anschlussvorrichtung (7) durch mechanisches Bearbeiten, insbesondere durch mechanisches Planarbearbeiten, hergestellt werden.

15. Verfahren nach Anspruch 14, **dadurch gekennzeichnet, dass** zur Erstellung der Kontaktflächen (12c) zunächst eine Auffütterung mit leitendem Material erfolgt, das dann mechanisch bearbeitet wird.

## Claims

1. Test device (1) for electrical testing of a test piece (2), in particular for the testing of wafers (3), having a contact head (6) which can be associated with the test piece (2) and is provided with contact elements (9) which are in the form of pins and form a contact pin arrangement, and having an electrical connecting apparatus (7), which has contact surfaces which make a touching contact with those ends of the contact elements (9) which face away from the test plane accommodating the test piece (2), **characterized in that** the contact surfaces are formed on axial contact elements (22) which extend in the axial direction and are in the form of mechanically processed contact surfaces (12c).

2. Test device according to claim 1, **characterized in that** the contact surfaces are in the form of contact surfaces (12c) produced by means of a single mechanical processing procedure.

3. Test device according to claim 1, **characterized in that** the contact surfaces are each in the form of contact surfaces (12c) which are mechanically processed to be planar in their own right and also with respect to one another.

4. Test device according to one of the preceding claims, **characterized in that** the axial contact elements (22) are solder raised areas (26).

5. Test device according to one of the preceding claims, **characterized in that** the axial contact elements (22) are soldered or welded conductive body raised areas (26).

6. Test device according to one of the preceding claims, **characterized in that** the connecting apparatus (7) has a printed circuit board (10), in particular a multilayer printed circuit board (10).

7. Test device according to one of the preceding claims, **characterized in that** the axial contact elements (22) are plated-through holes (30) in the printed circuit board (10).

8. Test device according to one of the preceding claims, **characterized in that** the printed circuit board (10) is a multilayer printed circuit board, and **in that** the plated-through holes (30) are located in an outer layer (29) of the printed circuit board (10).

9. Test device according to one of the preceding claims, **characterized in that** the layer (29) of the printed circuit board (10) together with the plated-through holes (30) has a mechanically processed surface.

10. Test device according to one of the preceding claims, **characterized in that** the plated-through holes (30) are formed throughout the entire volume, and in particular are metalized throughout the entire volume.

11. Test device according to one of the preceding claims, **characterized in that** the axial contact elements (22) are embedded in an electrically non-conductive, curing embedding compound, and **in that** the mechanical processing is then carried out.

12. Test device according to one of the preceding claims, **characterized in that** at least electrically conductive coating is applied to the contact surfaces after the mechanical processing.

13. Test device according to claim 12, **characterized in that** two or more coatings composed of the same and/or different materials are applied successively to the contact surfaces.

14. Method for production of a test device, according to one or more of the preceding claims, in which the contact surfaces (12c) of the connecting apparatus (7) are produced by mechanical processing, in particular by mechanical planar processing.

15. Method according to claim 14, **characterized in that** a covering of conductive material is applied first of all in order to create the contact surfaces (12c) and is then mechanically processed.

## Revendications

1. Dispositif de contrôle (1) pour le contrôle électrique d'un échantillon (2), notamment pour le contrôle de plaquettes (3), avec une tête de contact (6) associée à l'échantillon (2), pourvue d'éléments de contact (9) en forme de fiche, formant un agencement de fiches de contact et avec un dispositif de raccordement électrique (7) qui présente des surfaces de contact qui sont en contact avec les extrémités des éléments de contact (9) détournées du plan de contrôle recevant l'échantillon (2), **caractérisé en ce que** les surfaces de contact sont réalisées sur des éléments de contact axial (22) s'étendant dans la direction axiale en tant que surfaces de contact (12c) usinées mécaniquement.

2. Dispositif de contrôle selon la revendication 1, **caractérisé en ce que** les surfaces de contact sont réalisées en tant que surfaces de contact (12c) produites au moyen d'un seul processus d'usinage mécanique.

3. Dispositif de contrôle selon la revendication 1, **caractérisé en ce que** les surfaces de contact sont réalisées en tant que surfaces de contact (12c) usinées mécaniquement chacune de manière plane en elle ainsi que les unes par rapport aux autres.

4. Dispositif de contrôle selon l'une quelconque des revendications précédentes, **caractérisé en ce que** les éléments de contact axial (22) sont des bosses de brasure (21).

5. Dispositif de contrôle selon l'une quelconque des revendications précédentes, **caractérisé en ce que** les éléments de contact axial (22) sont des bosses de corps conducteur (26) brasées ou soudées.

6. Dispositif de contrôle selon l'une quelconque des revendications précédentes, **caractérisé en ce que** le dispositif de raccordement (7) présente une carte imprimée (10), notamment une carte imprimée multicouches (10).

7. Dispositif de contrôle selon l'une quelconque des revendications précédentes, **caractérisé en ce que** les éléments de contact axial (22) sont des connexions transversales (30) de la carte imprimée (10).

8. Dispositif de contrôle selon l'une quelconque des revendications précédentes, **caractérisé en ce que** la carte imprimée (10) est une carte imprimée multicouches et que les connexions transversales (30) se trouvent dans une couche externe (29) de la carte imprimée (10).

9. Dispositif de contrôle selon l'une quelconque des revendications précédentes, **caractérisé en ce que** la couche (29) de la carte imprimée (10) avec les connexions transversales (30) présente une surface usinée mécaniquement.

10. Dispositif de contrôle selon l'une quelconque des revendications précédentes, **caractérisé en ce que** les connexions transversales (30) sont réalisées à volume plein, notamment de manière métallisée à volume plein.

11. Dispositif de contrôle selon l'une quelconque des revendications précédentes, **caractérisé en ce que** les éléments de contact axial (22) sont encastrés dans une masse d'encastrement durcissante, électriquement non conductrice.

12. Dispositif de contrôle selon l'une quelconque des revendications précédentes, **caractérisé en ce qu'**au moins un revêtement électriquement conducteur est appliqué sur les surfaces de contact après l'usinage mécanique.

13. Dispositif de contrôle selon la revendication 12, **caractérisé en ce que** plusieurs revêtements de matériaux identiques et/ou différents sont appliqués successivement sur les surfaces de contact.

14. Procédé pour la fabrication d'un dispositif de contrôle selon l'une quelconque ou plusieurs des revendications précédentes, lors duquel les surfaces de contact (12c) du dispositif de raccordement (7) sont fabriquées par usinage mécanique, notamment par usinage planaire mécanique.

15. Procédé selon la revendication 14, **caractérisé en ce qu'**un garnissage avec du matériau conducteur, qui est ensuite usiné mécaniquement, est d'abord effectué pour la réalisation des surfaces de contact (12c).
